Europäisches Patentamt

(19) European Patent Office

Office européen des brevets

(11) Veröffentlichungsnummer : **0 162 149**
**B1**

(12) **EUROPÄISCHE PATENTSCHRIFT**

(45) Veröffentlichungstag der Patentschrift :
**19.07.89**

(21) Anmeldenummer : **84115953.6**

(22) Anmeldetag : **20.12.84**

(51) Int. Cl.⁴ : **H 01 G  1/14,** H 01 G  1/10,
H 01 G  1/035

(54) **Elektrischer Kondensator als Chip-Bauelement.**

(30) Priorität : **03.04.84 DE 3412492**

(43) Veröffentlichungstag der Anmeldung :
**27.11.85 Patentblatt 85/48**

(45) Bekanntmachung des Hinweises auf die Patenterteilung : **19.07.89 Patentblatt 89/29**

(84) Benannte Vertragsstaaten :
**AT CH DE FR GB IT LI SE**

(56) Entgegenhaltungen :
**EP—A— 0 130 001**
**EP—A— 0 130 386**
**DE—A— 3 134 617**
**GB—A— 1 335 159**
**GB—A— 2 027 274**
**US—A— 3 766 451**
**US—A— 3 778 532**
**US—A— 4 205 365**

(73) Patentinhaber : **Siemens Aktiengesellschaft Berlin
und München**
**Wittelsbacherplatz 2**
**D-8000 München 2 (DE)**

(72) Erfinder : **Utner, Ferdinand**
**Roter Brachweg 99**
**D-8400 Regensburg (DE)**
Erfinder : **Bolz, Herbert, Dipl.-Ing.**
**Hebelstrasse 5**
**D-7135 Wiernsheim-Serres (DE)**

Beschreibung

Die Erfindung betrifft einen elektrischen Kondensator mit Kunststoffdielektrikum als Chip-Bauelement, das durch Lötung auf Schaltplatten gedruckter Schaltungen befestigbar ist mit den Merkmalen : der Kondensatorkörper ist in Stapel- bzw. Schichtbauweise oder als flachgepreßter Wickel ausgeführt und enthält alternierend in gegenüberliegenden Stirnflächen des Kondensatorkörpers endende Belegungen und diese auf den Stirnflächen elektrisch leitend verbindende Metallauflagen sowie an den Metallauflagen elektrisch leitend und mechanisch befestigte Stromzuführungen, die aus Bändern aus biegsamem lötfähigem Metall bestehen und jeweils mit einem Ende an den Metallauflagen befestigt sind, der Kondensatorkörper ist samt den Enden der Bänder in einer quaderförmigen Umhüllung aus hochtemperaturbeständigem Kunststoff untergebracht, der den Einflüssen des Lotflußmittels, des flüssigen Lotes sowie der chemischen flüssigen Reinigungsmittel wiedersteht.

Die Erfindung betrifft ferner ein Verfahren zur Herstellung eines solchen elektrischen Kondensators, bei dem ein Metallband zunächst mit Ausnehmungen derart versehen wird, daß Bänder gebildet werden, danach die Kondensatorkörper zwischen die Bänder eingesetzt, mit den Bändern verbunden und mit der Umhüllung versehen werden.

Stapel- bzw. Schichtkondensatoren im Sinne der vorliegenden Erfindung sind beispielsweise in der DE-PS 1 764 541 (entsprechend den US-PSen 3 670 378 und 3 728 765) beschrieben und auch durch umfangreiche Lieferungen bekannt.

Ebenso sind Kondensatoren mit einem Kondensatorkörper aus einem flachgepreßten Wickel hinreichend durch Lieferungen bekannt und in zahlreichen Literaturstellen beschrieben.

Es sind auch keramische Vielschichtkondensatoren bekannt und beispielsweise in der US-PS 3 740 624 beschrieben, die aus einem monolithischen Block aus keramischem dielektrischen Material bestehen, der in seinem Inneren alternierend zu unterschiedlichen Stirnseiten geführte 10 Metallschichten als Belegungen enthält, die an diesen Stirnflächen miteinander elektrisch leitend durch Me-tallauflagen verbunden sind.

Ferner sind elektrische Kondensatoren bekannt, die aus einem homogenen Keramikkörper bestehen, der an gegenüberliegenden Oberflächen Belegungen enthält, die mit Stromzuführungen verbunden sind.

Die vorliegende Erfindung ist bei allen Kondensatoren der hier beschriebenen Art anwendbar, vorzugsweise jedoch bei solchen Kondensatoren, deren Dielektrikum aus Kunststoff besteht, der gegen die Einwirkungen von Flußmitteln, flüssigen und damit heißen Loten und flüssigen chemischen Reinigungsmitteln empfindlich ist. Solche Kunststoffe sind beispielsweise Polyethylenterephthalat, Polykarbonat, Polypropylen, Zelluloseacetat und ähnliches.

Aber auch Kondensatoren mit einem keramischen, insbesondere monolithischem Dielektrikumskörper sind gegen die Einflüsse der bei der Befestigung solcher elektrischer Bauelemente bei der Befestigung als Chip-Bauelemente auf gedruckten Schaltungsplatten empfindlich. Beispielsweise können sich 10 durch die Wärmeeinwirkung die dielektrischen Eigenschaften im ungünstigen Sinne verändern, und auch die chemischen Einflüsse des Flußmittels und der zu verwendenden Reinigungsmittel sind in vielen Fällen nicht ohne Einfluß auf die Eigenschaften solcher Kondensatoren. Man hat schon versucht, solche Bauelemente mit speziell ausgebildeten Umhüllungen zu versehen, um sie für die Verwendung als Chip-Bauelemente geeignet zu machen. Bei dieser Verwendung werden Lote verwendet, die im flüssigen Zustand Temperaturen bis 260 °C aufweisen, und der Lötvorgang dauert ca. 10 Sekunden.

In der DE-OS 31 34 617 ist ein Folien-Kondensator in Chip-Bauweise mit an einander gegenüberliegenden Stirnflächen vorgesehenen lötfähigen Anschlußschichten beschrieben, bei dem mit den Anschlußschichten jeweils ein sich quer über die Anschlußschicht zumindest einseitig darüberhinaus erstreckendes, einen Teil der Fläche der Anschlußschicht abdeckendes Kontaktelement verlötet ist, und bei dem die überstehenden Enden dieses Kontaktelementes mit Abstand zum Kondensatorkörper senkrecht zur stirnseitigen Anschlußschicht abgewinkelt sind. Bei diesem Folien-Kondensator kann unter anderem auch der Kondensatorkörper in einen Becher eingesetzt und mit Gießharz vergossen sein, wobei die aus der Becheröffnung ragenden Anschlußelemente mit Abstand vom Becherrand rechtwinklig nach innen abgebogen sind. Durch den Abstand der abgewinkelten Teile der Anschußelemente vom Kondensatorkörper oder vom vergossenen Becher wird gewährleistet, daß temperaturempfindliche Bauelemente in Chipbauweise ohne Gefahr einer Beschädigung oder Funktionsbeeinträchtigung den Lötvorgängen ausgesetzt und damit insbesondere unmittelbar in gedruckten Schaltungen verwendet werden kann. Das Bauelement kommt dabei mit dem Lot keinesfalls in Berührung.

In der DE-AS 10 64 127 ist beschrieben, daß für Schaltungselemente zur Bestückung von sog. gedruckten Schaltungen besondere Erfordernisse notwendig sind. Sie müssen aus einem Lötzinn abstoßenden, hitzebeständigen Grundkörper bestehen oder in eine Lötzinn abstoßende, hitzebeständige Isolierung eingehüllt, eingelegt oder eingebettet sein, und die Elektrodenanschlüsse sollten unter Wegfall von äußeren Anschußdrähten durch metallisierte Enden oder Kappen gebildet sein. In den Figuren 6 und 7 dieser Druckschrift sind für das dort beschriebene Verfahren geeignete Wickelkondensatoren gezeigt. Ein Kondensatorwickel, der Anschlußfolien aufweist, ist in einem Isolierrohr eingesetzt, das mit Isolierpfropfen verschlossen ist. Anstelle von Anschlußkappen sind die Anschlußfolien durch die Isolierpfropfen hindurch herausgeführt und so umgelegt, daß sie die Aufgaben der Kappen übernehmen können. Die Anschlußfolien müssen dabei mindestens auf einer gemeinsamen linearen Mantellinie des Isolierkörpers liegen. Auch diese Kondensatoren können auf der Isoliergrundplatte für die gedruckten Schaltungen befestigt und durch Tauchlötung mit den Leitungen verbunden werden.

In der DE-PS 31 20 298 ist ein Kondensator in Chip-Bauweise mit einem aus Folien aufgebautem Kondensatorkörper beschrieben, dessen einander gegenüberliegende Stirnflächen mit lötfähigen Anschlußschichten versehen sind, denen jeweils ein zumindest im wesentlichen kappenförmiges Metallteil zugeordnet ist. Bei diesem Kondensator ist jedes Metallteil ein getrennt hergestelltes Teil aus lötbeständigem Material mit wenigstens einer Öffnung im Bodenbereich, wobei zwischen Anschlußschicht und Metallteil eine sich zumindest in die Öffnung erstreckende Lotverbindung ausgebildet ist. Diese Ausführungsform setzt voraus, daß beim Einbau in eine Schaltplatte das flüssige Lot nur an die Metallteile gelangt, nicht aber an den eigentlichen Kondensatorkörper.

Bei der normalen Verwendung solcher Chip-Bauelemente bei Schaltungsplatten gedruckter Schaltungen wird aber in aller Regel das sogenannten Schwallötverfahren verwendet, bei dem die Bauelemente nahezu vollständig mit flüssigem Lot von bis 260 °C für etwa 10 Sekunden in Berührung kommen, insbesondere wenn die Bauelemente auf der Verdrahtungsseite der Schaltungsplatte angeordnet sind.

Der vorliegenden Erfindung liegt die Aufgabe zugrunde, einen elektrischen Kondensator der eingangs angegebenen Art derart zu gestalten, daß die Forderungen an Bestückungssicherheit durch exakte geometrische Abmessungen, an Klebesicherheit durch die Möglichkeit der genauen Positionierung der Bauelemente an den Stellen der Schaltungsplatte, mit denen die Kondensatoren verbunden werden sollen, ferner an die Lötfähigkeit der Anschlußflächen gewährleistet sind und die schädigenden Einflüsse der Fluß- und Reinigungsmittel sowie des flüssigen heißen Lotes ausgeschaltet sind.

Zur Lösung dieser Aufgabe ist der elektrische Kondensator der eingangs angegebenen Art erfindungsgemäß gekennzeichnet durch die weiteren Merkmale, daß die Bänder ihren befestigten Enden wenigstens eine als Wärmefalle dienende Verjüngung aufweisen und daß die aus der Umhüllung herausgeführten Bänder derart verbogen sind, daß die an der Oberfläche der Umhüllung Lötflächen bildend verlaufen.

Es ist vorteilhaft, wenn zwischen den Metallauflagen und den im Inneren der Umhüllung verlaufenden Teilen der Bänder einerseits und dem Kunststoff der Umhüllung andererseits Haftvermittler enthalten ist.

Die Enden der Bänder können mit den Metallauflagen verlötet, verschweißt oder mittels leitendem Kleber verbunden sein.

Die Enden der Bänder können mit den Metallauflagen aber auch durch Druckkontakt verbunden sein, wobei der mechanische Halt durch die Umhüllung gewährleistet ist.

Ferner können die Bänder vor den befestigten Enden Abknickungen aufweisen, die zum Ausgleich von Abmessungstoleranzen der Kondensatorkörper dienen.

Weitere vorteilhafte Ausführungsformen sind durch die Merkmale der Unteransprüche 6 bis 13 gekennzeichnet und werden zusammen mit den Zeichnungen erläutert.

Das Verfahren der eingangs angegebenen Art zur Herstellung eines solchen elektrischen Kondensators ist zur Lösung der Aufgabe erfindungsgemäß dadurch gekennzeichnet, daß die Umhüllung derart um die Kondensatorkörper 25 und die Bänder geformt wird, daß Teile der Bänder aus der Umhüllung herausragen, und daß die aus der Umhüllung herausragenden Teile vom Metallband abgetrennt und dann an der Oberfläche der Umhüllung verlaufend umgebogen werden.

Durch die Erfindung wird die ihr zugrunde liegende Aufgabe in befriedigender Weise gelöst. So können die Toleranzen der äußeren Abmessungen der Umhüllung, die für einen Einsatz solcher Bauelemente als Chip besonders wichtig sind, sehr exakt eingehalten werden. Die Abmessungen sind unabhängig von eventuellen herstellungsbedingten Toleranzen der Kondensatorkörper. Entsprechendes gilt für die Lötfähigkeit der Lötflächen. Ferner resultiert der Vorteil, daß als Material für die Umhüllung ein Kunststoff verwendet werden kann, der flammhemmend bzw. selbstlöschend und unempfindlich gegen chemische Einflüsse ist. Der für die Umhüllung zu verwendende Kunststoff weist eine ausreichende Wärmedämmung auf. Als solche Kunststoffe können z. B. Epoxidharze, Silikonharze, oder Polyphenylensulfid (PPS) verwendet werden, die in aller Regel mit mineralischen und/oder Glasphaserfüllstoffen gefüllt sind. Bei entsprechenden Füllgrad können auch Phenolharze eingesetzt werden. Voraussetzung ist natürlich, daß sowohl die Bauelemente als auch die Kunststoffe die bei der Herstellung der Umhüllung auftretenden Belastungen aushalten.

Bevorzugt ist die Anwendung der Erfindung bei Stapel- bzw. Schichtkondensatoren mit Polyethylenterephthalat als Dielektrikum und Polyphenylensulfit (PPS) als Umhüllungsmaterial, insbesondere, wenn die Kondensatorkörper nach der Herstellung einer zusätzlichen Wärmebehandlung unterworfen worden sind und dadurch einen Kristallisationsgrad von wenigstens 50 % aufweisen, wie dies in der prioritätsgleichen europäischen Patentanmeldung EP-A 0 162 144 beschrieben ist.

Die Erfindung wird nachfolgend anhand der in den Figuren dargestellten Ausführungsbeispielen näher erläutert.

Es zeigen :

Fig. 1 einen elektrischen Kondensator in Seitenansicht, die Fig.

2,3 u. 5 bevorzugte Ausführungsformen in perspektivischer Darstellung, die Fig.

4,6 u.8 weitere Ausführungsformen der Erfindung, die Fig.

7,9,10,11 Ausschnitte zur Erläuterung der Befestigungsart, die Fig.

12 u. 13 besondere Ausführungsformen der Befestigung zum Ausgleich von Toleranzen,

Fig. 14 zwei weitere Möglichkeiten der Befestigung der Stromzuführungen,

Fig. 15 den Ablauf des Herstellungsverfahrens und

Fig 16 einen Ausschnitt aus dem Herstellungsverfahren der die Befestigung der Stromzuführungen erläutert.

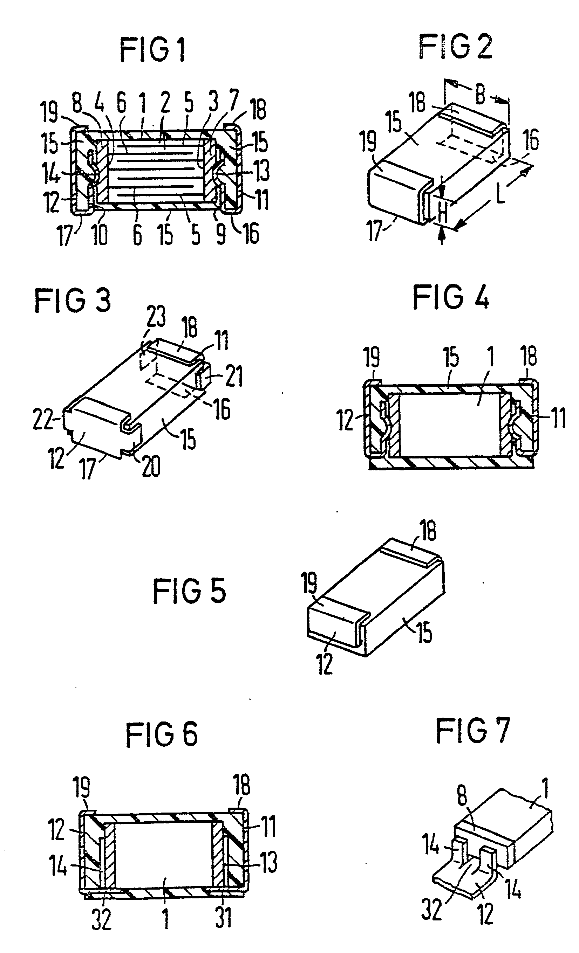

In Fig. 1 ist der Kondensatorkörper 1 dargestellt, der aus den Dielektrikumslagen 2 besteht. Zwischen den Dielektrikumslagen 2 sind die Belegungen 5 und 6 angeordnet, die alternierend in den gegenüberliegenden Stirnflächen 3 und 4 enden. Auf diesen Stirnflächen 3 und 4 sind Metallauflagen 7 und 8 aufgebracht, insbesondere durch Metallspritzen aufgeschoopt, die dazu dienen, die Belegungen 5 und 6 elektrisch miteinander zu verbinden. An den Metallauflagen 7 und 8 sind Stromzuführungen 9 und 10 befestigt, die aus Bändern 11 und 12 bestehen, deren Enden 13 und 14 mit den Metallauflagen 7 und 8 verlötet, verschweißt oder mittels leitendem Kleber befestigt sind. Der gesamte Kondensatorkörper und Teile der Bänder 11 und 12 sind mit einer Umhüllung 15 umgeben, die aus hochhitzebeständigem Isolierstoffmaterial besteht.

Die Stromzuführungen 9 und 10 treten gemäß Fig. 1 unten aus der Umhüllung 15 heraus und sind dann längs der Oberfläche verlaufend umgebogen, so daß Lötflächen 16 und 17 an der Unterseite bzw. 18 und 19 an der Oberseite vorhanden sind. An diesen Lötflächen wird der Kondensator mit den betreffenden Stellen der gedruckten Schaltungsplatte durch Lötung verbunden.

In Fig. 2 ist perspektivisch ein Kondensator gezeigt, der dem der Fig. 1 entspricht. Die Länge L, die Breite B und die Höhe H der Isolierstoffumhüllung 15 können durch für solche Zwecke an sich bekannte Herstellverfahren mit sehr engen Toleranzen hergestellt werden.

In Fig. 3 ist ein Kondensator gezeigt, dessen als Stromzuführungen dienende Bänder 11 und 12 zusätzliche Lötflächen 20 und 21 bzw. 22 und 23 aufweisen. Diese Lötflächen sind durch Umbiegen entsprechend vorgefertigter Laschen entstanden.

In Fig. 4 ist ein Kondensator gezeigt, bei dem die Bänder 11 und 12 im Gegensatz zum Kondensator gemäß Fig. 1 seitlich aus der Isolierstoffumhüllung 15 heraustreten und dann nach oben abgebogen sind, wodurch die Lötflächen 18 und 19 entstanden sind.

Ein solcher Kondensator ist perspektivisch in Fig. 5 dargestellt.

In den Fig. 6 und 7 ist eine andere Ausführungsform des Kondensators gemäß den Fig. 4 und 5 gezeigt, wobei zur Abstützung und zur genaueren Positionierung des Kondensatorkörpers 1 aus dem Ende 14 der Bänder 11 und 12 zusätzliche Laschen 31 und 32 gebildet sind. Die Enden 13 und 14 der Bänder 11 und 12 sind nach oben abgebogen, während die Laschen 31 und 32 nicht abgebogen sind und beim Herstellungsverfahren als Auflage für den Kondensatorkörper 1 dienen.

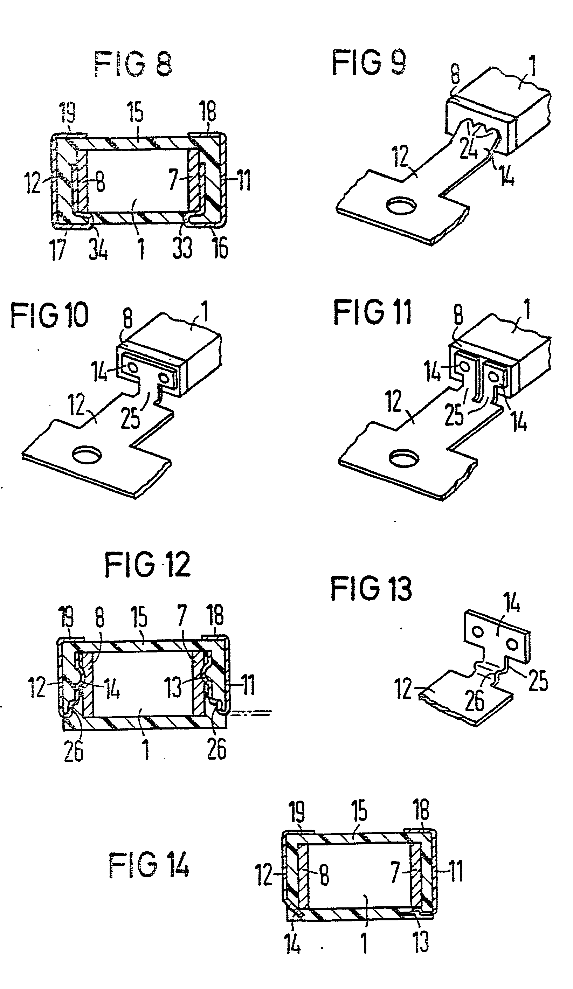

In Fig. 8 ist wiederum eine andere Ausführungsform eines Kondensators gezeigt, wobei die unteren Lötflächen 16 und 17 vergrößert sind, ohne daß die gesamte Länge des Chip-Bauelementes mit den voran beschriebenen Ausführungsformen vergrößert ist. Die Verlängerung der Lötflächen 16 und 17 wird durch U-förmige Abbiegungen 33 und 34 erzielt. Vergrößerte Lötflächen sind dann erforderlich, wenn die Dicke der Umhüllung 15 gering ist, so daß die notwendige Lötfläche von mindestens 1 mm Breite unterschritten würde.

In Fig. 9 ist schematisch gezeigt, daß die Verbindung zwischen dem Ende 14 des Bandes 12 und der Metallauflage 8 des Kondensatorkörpers 1 auch durch Druckkontakte 24 bewirkt sein kann. Der notwendige Halt der Bänder wird in einem solchen Fall durch die Umhüllung 15 bewirkt.

Fig. 10 zeigt, daß zum Zwecke der Verringerung des Wärmeüberganges das Band 12 mit einer Einengung 25 versehen sein kann, die vor dem Ende 14 angeordnet ist. Diese Verengung 25 bewirkt einerseits, daß beim Löt- oder Schweißvorgang sich die zugeführte Wärme über das verbreiterte Ende 14 ausbreiten kann, so daß punktförmige Erwärmung vermieden wird. Andererseits sorgt die Verengung 25 dafür, daß beim Lötvorgang zum Zwecke des Einsetzens in die Schaltplatte der Wärmezufluß zur Verbindungsstelle verringert wird. Durch die Verengung 25 wird auch eine gewisse Federwirkung erzielt, die beim Herstellungsverfahren vorteilhaft sein kann.

In Fig. 11 ist eine andere Art der Ausbildung des Endes 14 des Bandes 12 gezeigt, indem nämlich zwei Verengungen 25 angeordnet sind.

Die Fig. 12 und 13 zeigen eine Ausführungsform der Bänder 11 und 12, bei der die Bänder 11 und 12 vor ihren Enden 13 und 14 mit einer Abknickung 26 versehen sind, die dazu dient, herstellungsbedingte Abmessungstoleranzen des Kondensatorkörpers auszugleichen.

In Fig. 14 sind zwei andere Ausführungsformen der Enden 13 und 14 der Bänder 12 dargestellt. Diese beiden Ausführungsformen treten natürlich nicht gemeinsam bei einem Kondensator auf, sondern sind jeweils symmetrisch zu beiden Seiten eines Kondensators vorhanden.

Das Ende 13 des Bandes 11 ist mit der Metallauflage 7 nicht stirnseitig, sondern randseitig verbunden.

Das Ende 14 des Bandes 12 ist schräg abgebogen und sorgt dafür, daß durch die Berührung mit der Kante der Metallauflage 8 eine verbesserte Schweißverbindung resultiert.

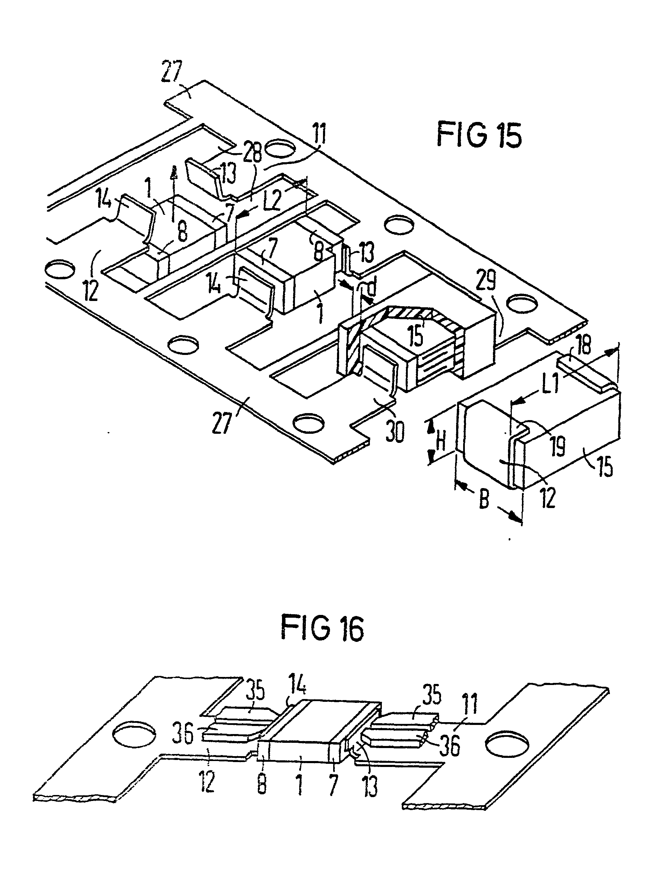

In Fig. 15 ist das Herstellungsverfahren gezeigt. Ein Band 27 aus beidseitig feuerverzinntem, insbesondere mit Zinn-Blei-Lot versehenem biegsamen Metall mit einer Auflage von etwa 4 bis 8 μ je Seiten ist mit Ausnehmungen 28 derart versehen, daß die als Stromzuführungen 9 und 10 dienenden Bänder 11 und 12 mit dem Band verbunden bleiben. Derartige Bänder und Verfahrensschritte sind an sich aus der Halbleitertechnik, insbesondere der IC-Technik bekannt.

Die Enden 13 und 14 der Bänder 11 und 12 sind nach oben gebogen.

Im Verlauf des weiteren Verfahrens werden die Bauelementekörper 1 samt Metallauflagen 7 und 8 zwischen die Bänder 11 und 12 geschoben.

Im nächsten Verfahrensschritt werden die Enden 13 und 14, wie beispielsweise im Zusammenhang mit Fig. 16 beschrieben, mit den Metallauflagen 7 und 8 verbunden.

Die Länge $L_2$ des Kondensatorkörpers 1 kann herstellungsbedingt schwanken. Es sind oben eine Reihe von Möglichkeiten beschrieben und in den Figuren dargestellt, wie diese herstellungsbedingten Abmessungstoleranzen der Länge $L_2$ des Bauelementekörpers 1 ausgeglichen werden können.

Im nächsten Verfahrensschritt wird um den Bauelementekörper 1 und Teile der Bänder 12 und 13 eine Umhüllung 15 aus oben beschriebenem Kunststoff erzeugt, deren Dicke d mindesten 0,1 mm beträgt und deren Abmessungen — wie im Zusmmenhang mit Fig. 2 erläutert — engtoleriert sind. Hierfür verwendbare Herstellungsverfahren sind hinreichend bekannt, beispielsweise bei der Herstellung von Umhüllungen für Halbleiterbauelemente und integrierte Schaltungen (IC) durch Umpressen, Umspritzen, Umsintern.

· Im nächsten Verfahrensschritt werden die mit der Umhüllung 15 versehenen Kondensatoren vom Band abgetrennt, so daß einzelne Körper vorliegen, bei denen Teile 29 und 30 der Bänder 11 und 12 aus der Umhüllung 15 herausragen. Diese herausragenden Teile 29 und 30 der Bänder 11 und 12 werden längs der Oberfläche der Umhüllung 15 verlaufend umgebogen, so daß zumindest die Lötflächen 18 und 19 entstehen.

Die Länge $L_1$ des ·Bauelementes gemäß Fig. 15 schließt die Dicke der Bänder 11 und 12 mit ein.

In Fig. 16 ist gezeigt, daß die Enden 13 und 14 der Bänder 11 und 12 an die Metallauflagen 7 und 8 des Kondensatorkörpers 1 mittels Schweißelektroden 35 und 36 angeschweißt werden, wobei diese Schweißelektroden parallel zu den Bändern geführt werden.

Es ist natürlich auch möglich, bei diesem Arbeitsschritt andere Kontaktierverfahren einzusetzen, beispielsweise Ultraschallschweißen, Perkussionsschweißen, sowie diverse Lötverfahren, beispielsweise Schwallötung, Hochfrequenzinduktionslöten oder Laserlöten.

Zur Verbesserung der Feuchtesicherheit der elektrischen Kondensatoren kann es vorteilhaft sein, die Kondensatorkörper nach dem Anbringen der Metallauflagen 7 und 8 mit Heißwachs zu imprägnieren und/oder mit einer Isolierschicht zu versehen.

Vor dem Anbringen der Umhüllung 15 ist es in manchen Fällen angebracht bzw. erforderlich, zumindest die Oberflächen der Metallteile mit einer Schicht aus Haftvermittler zu versehen, damit die Haftung der Umhüllung am Kondensatorkörper, zumindest aber an dessen Metall-teilen verbessert ist. Solche Haftvermittler sind an sich bekannt.

## Patentansprüche

1. Elektrischer Kondensator mit Kunststoffdielektrikum als Chip-Bauelement, das durch Lötung auf Schaltplatten gedruckter Schaltungen befestigbar ist mit den Merkmalen :

a) der Kondensatorkörper (1) ist in Stapel- bzw. Schichtbauweise oder als flachgepreßter Wickel ausgeführt und

b) enthält alternierend in gegenüberliegenden Stirnflächen (3, 4) des Kondensatorkörpers (1) endende Belegungen (5, 6) und diese auf den Stirnflächen (3, 4) elektrisch leitend verbindende Metallauflagen (7, 8) sowie an den Metallauflagen (7, 8) elektrisch leitend und mechanisch befestigte Stromzuführungen (9, 10), die

c) aus Bändern (11, 12) aus biegsamem lötfähigem Metall bestehen und jeweils mit einem Ende (13, 14) an den Metallauflagen (7, 8) befestigt sind und

d) der Kondensatorkörper (1) ist samt den Enden (13, 14) der Bänder in einer quaderförmigen Umhüllung (15) aus hochtemperaturbeständigem Kunststoff untergebracht, der den Einflüssen des Lotflußmittels, des flüssigen Lotes sowie der chemischen flüssigen Reinigungsmittel widersteht,
gekennzeichnet durch die weiteren Merkmale

e) die Bänder (11, 12) weisen vor ihren befestigten Enden (13, 14) wenigstens eine als Wärmefalle dienende Verjüngung (25) auf,

f) die aus der Umhüllung (15) herausgeführten Bänder (11, 12) sind derart verbogen, daß sie an der Oberfläche der Umhüllung (15) Lötflächen (16, 17, 18, 19, 20, 21, 22, 23) bildend verlaufen.

2. Elektrischer Kondensator nach Anspruch 1, dadurch gekennzeichnet, daß zwischen den Metallauflagen (7, 8) und den im Inneren der Umhüllung verlaufenden Teilen der Bänder (11, 12) einerseits und dem Kunststoff der Umhüllung (15) andererseits Haftvermittler enthalten ist.

3. Elektrischer Kondensator nach Anspruch 1, dadurch gekennzeichnet daß die Enden (13 14) der Bänder (11, 12) mit den Metallauflagen (7, 8) verlötet, verschweißt oder mittels leitendem Kleber verbunden sind.

4. Elektrischer Kondensator nach Anspruch 1, dadurch gekennzeichnet, daß die Enden (13, 14) der Bänder (11, 12) mit den Metallauflagen (7, 8) durch Druckkontakte (24) verbunden sind, wobei der mechanische Halt durch die Umhüllung (15) gewährleistet ist.

5. Elektrischer Kondensator nach einem der Ansprüche 1 bis 3, dadurch gekennzeichnet, daß die Bänder (11, 12) vor den befestigten Enden (13, 14) Abknickungen (26) aufweisen, die zum Ausgleich von Abmessungstoleranzen der Kondensatorkörper (1) dienen.

6. Elektrischer Kondensator nach Anspruch 1, dadurch gekennzeichnet, daß die als Wärmefalle dienende Verjüngung (25) in einer weiteren Ausführung aus zwei Segmenten (25) besteht und daß die Enden (13, 14) der Bänder sich jeweils in zwei Segmente (25) verzweigen und dabei mit den zwei Segmenten (25) der Verengung verbunden sind.

7. Elektrischer Kondensator nach Anspruch 1, dadurch gekennzeichnet, daß der Kondensator eine obere Belegung (5) und eine untere Belegung (6) und gegenüberliegende Stirnflächen (3, 4) hat und daß die Bänder (11, 12) auf der Unterseite des Kondensators jeweils aus der Kunststoffumhüllung (15) heraustreten, danach zu den jeweiligen Stirnseiten umgebogen sind und an den Stirnseiten bis an die Oberseite des Kondensators reichend entlanglaufen und sich über einen Teil der Oberfläche erstrecken, wodurch sie zwei Paare (16, 18) und (17, 19) jeweils einander gegenüberliegender unterer und oberer Kontaktflächen bilden.

8. Elektrischen Kondensator nach Anspruch 6, dadurch gekennzeichnet, daß die Bänder (11, 12) zusätzliche Lötflächen (20, 21) und (22, 23) aufweisen, die sich jeweils über einen Teil der vorderen Stirnfläche (15) des Kondensatorkörpers (1), bzw. über die ihr gegenüberliegende hintere Stirnfläche erstrecken.

9. Elektrischer Kondensator nach Anspruch 7, dadurch gekennzeichnet, daß durch U-förmige Abbiegungen (33, 34) eine Vergrößerung der unteren Lötflächen (16, 17) erzielt wird.

10. Elektrischer Kondensator nach Anspruch 1, dadurch gekennzeichnet, daß die Bänder (11, 12) seitlich aus der Umhüllung (15) heraustreten, dann nach oben abgebogen sind, und auf der Oberseite des Kondensatorkörpers (1) Lötflächen (18, 19) bilden.

11. Elektrischer Kondensator nach Anspruch 1, dadurch gekennzeichnet, daß in einer weiteren Ausführungsform des Kondensators aus den Enden (13, 14) der Bänder (11, 12) zusätzliche Laschen (31, 32) gebildet sind, wobei die jeweils zwei Teile der Enden (13, 14) der Bänder (11, 12) nach oben abgebogen sind, während die Laschen (31, 32) nicht abgebogen sind und als Auflage für den Kondensatorkörper (1) dienen.

12. Elektrischer Kondensator nach Anspruch 1, dadurch gekennzeichnet, daß die Bänder (11, 12) an den Metallauflagen (7, 8) nicht stirnseitig, sondern randseitig befestigt sind.

13. Elektrischer Kondensator nach Anspruch 1, dadurch gekennzeichnet, daß die Bänder (11, 12) mit den aus Stirnseite und Randseite gebildeten Ecken der Metallauflagen (7, 8) verbunden sind.

14. Verfahren zur Herstellung eines elektrischen Kondensators nach einem der vorangehenden Ansprüche, bei dem ein Metallband (27) zunächst mit Ausnehmungen (28) derart versehen wird, daß die Bänder (11, 12) gebildet werden, danach die Kondensatorkörper (1) zwischen die Bänder (11, 12) eingesetzt, mit den Bändern (11, 12) verbunden und mit der Umhüllung (15) versehen werden, dadurch gekennzeichnet, daß die Umhüllung (15) derart um die Kondensatorkörper (1) und die Bänder (11, 12) geformt wird, daß Teile (29, 30) der Bänder (11, 12) aus der Umhüllung (15) herausragen, und daß die aus der Umhüllung (15) herausragenden Teile (29, 30) vom Metallband (27) abgetrennt und dann an der Oberfläche der Umhüllung (15) verlaufend umgebogen werden.

**Claims**

1. Electric capacitor with a plastic dielectric as a chip component which can be mounted by soldering on circuit boards of printed circuits, having the features :

a) the capacitor body (1) is constructed in stacked or layered construction or as a coil which is pressed flat and

b) contains coatings (5, 6) which alternatingly end in opposite front faces (3, 4) of the capacitor body (1) and metal supports (7, 8) which electrically conductively connect the coatings at the front faces (3, 4) and current leads (9, 10) which are electrically conductively and mechanically attached to the metal supports (7, 8), which leads

c) consist of bands (11, 12) of flexible solderable metal and are in each case attached with one end (13, 14) to the metal supports (7, 8) and

d) the capacitor body (1), together with the ends (13, 14) of the bands, is accommodated in a cube-shaped sheathing (15) of high-temperature-resistant plastic which resists the influences of the solder flux, the liquid solder and the chemical liquid cleaning agent,
characterised by the further features that

e) the bands (11, 12) exhibit in front of their attached ends (13, 14) at least one tapering (25) which acts as a heat trap,

f) the bands (11, 12) carried out of the sheathing (15) are bent in such a manner that they extend at the surface of the sheathing (15) forming soldering areas (16, 17, 18, 19, 20, 21, 22, 23).

2. Electric capacitor according to Claim 1, characterised in that between the metal supports (7, 8) and the parts of the bands (11, 12) extending in the interior of the sheathing, on the one hand, and the plastic of the sheathing (15), on the other hand, bonding agent is contained.

3. Electric capacitor according to Claim 1, characterised in that the ends (13, 14) of the bands (11, 12) are soldered, welded or connected by means of conductive adhesive to the metal supports (7, 8).

4. Electric capacitor according to Claim 1, characterised in that the ends (13, 14) of the bands (11, 12) are connected by pressure contacts (24) to the metal supports (7, 8), the mechanical strength being ensured by the sheathing (15).

5. Electric capacitor according to one of Claims 1 to 3, characterised in that the bands (11, 12) exhibit in front of the attached ends (13, 14) bent sections (26) which are used for compensating dimensional tolerances of the capacitor body (1).

6. Electric capacitor according to Claim 1, characterised in that the tapering (25) used as a heat trap consists of two segments (25) in another embodiment and that the ends (13, 14) of the bands in each case branch into two segments (25) and in this arrangement are connected to the two segments (25) of the narrowing.

7. Electric capacitor according to Claim 1, characterised in that the capacitor has an upper coating (5) and a lower coating (6) and opposite front faces (3, 4) and that the bands (11, 12) in each case emerge from the plastic sheathing (15) on the underside of the capacitor, are then bent towards the respective front faces and extend along the front faces up to the top of the capacitor and extend over a part of the surface, as a result of which they form two pairs (16, 18) and (17, 19) of in each case mutually opposite lower and upper contact areas.

8. Electric capacitor according to Claim 6, characterised in that the bands (11, 12) exhibit additional soldering areas (20, 21) and (22, 23) which in each case extend over a part of the forward front face (15) of the capacitor body (1) or over the rear front face opposite to the former, respectively.

9. Electric capacitor according to Claim 7, characterised in that an enlargement of the lower soldering areas (16, 17) is achieved by U-shaped bands (35, 34).

10. Electric capacitor according to Claim 1, characterised in that the bands (11, 12) emerge laterally from the sheathing (15), are then bent away towards the top and form soldering areas (18, 19) at the top of the capacitor body (1).

11. Electric capacitor according to Claim 1, characterised in that in another embodiment of the capacitor, additional lugs (31, 32) are formed from the ends (13, 14) of the bands (11, 12), in which arrangement the in each case two parts of the ends (13, 14) of the bands (11, 12) are bent away towards the top whilst the lugs (31, 32) are not bent away and are used as support for the capacitor body (1).

12. Electric capacitor according to Claim 1, characterised in that the bands (11, 12) are not attached to the front face but to the edge at the metal supports (7, 8).

13. Electric capacitor according to Claim 1, characterised in that the bands (11, 12) are connected to the corners, formed of front face and edge, of the metal supports (7, 8).

14. Method for producing an electric capacitor according to one of the preceding claims, in which a metal band (27) is first provided with recesses (28) in such a manner that the bands (11, 12) are formed, after which the capacitor bodies (1) are inserted between the bands (11, 12), connected to the bands (11, 12) and provided with the sheathing (15), characterised in that the sheathing (15) is formed around the capacitor body (1) and the bands (11, 12) in such a manner that parts (29, 30) of the bands (11, 12) protrude from the sheathing (15) and that the parts (29, 30) protruding from the sheathing (15) are separated from the metal band (27) and are then bent around extending at the surface of the sheathing (15).

## Revendications

1. Condensateur électrique réalisé comme un composant en forme de pastille et contenant une matière plastique en tant que diélectrique, pouvant être fixé par soudage sur des plaques à circuits imprimés et ayant les particularités suivantes :

a) le corps (1) du condensateur est réalisé selon le mode de construction à empilage ou à couches ou est réalisé comme un enroulement aplati par pression et

b) contient des armatures (5, 6) se terminant alternativement dans des faces frontales (3, 4) opposées du corps (1) du condensateur, des revêtements métalliques (7, 8) qui relient ces armatures électriquement entre elles sur les faces frontales (3, 4), ainsi que des amenées de courant (9, 10) reliées électriquement et fixées mécaniquement aux revêtements métalliques (7, 8), amenées de courant qui

c) sont formées de bandes (11, 12) de métal flexible et soudable et sont fixées chacune par une extrémité (13, 14) aux revêtements métalliques (7, 8) et

d) le corps (1) du condensateur est disposé, ensemble avec les extrémités (13, 14) des bandes, dans un enrobage parallélépipédique (15) d'une matière plastique supportant des températures élevées et qui résiste aux influences du flux décapant, de la soudure liquide et des nettoyants chimiques liquides,
caractérisé par les particularités supplémentaires

e) les bandes (11, 12) présentent au moins un rétrécissement (25) servant de piège thermique et se trouvant devant leurs extrémités fixées (13, 14) et

f) les bandes (11, 12) sorties de l'enrobage (15) sont recourbées de manière qu'elles s'étendent le long de la surface de l'enrobage (15) en formant des faces de soudage (16, 17, 18, 19, 20, 21, 22, 23).

2. Condensateur selon la revendication 1, caractérisé en ce qu'un agent adhésif est contenu entre les revêtements métalliques (7, 8) et les parties des bandes (11, 12) situées à l'intérieur de l'enrobage d'une part et la matière plastique de l'enrobage (25) d'autre part.

3. Condensateur selon la revendication 1, caractérisé en ce que les extrémités (13, 14) des bandes (11, 12) sont reliées aux revêtements métalliques (7, 8) par brasage, soudage ou au moyen d'une colle conductrice.

4. Condensateur selon la revendication 1, caractérisé en ce que les extrémités (13, 14) des bandes (11, 12) sont reliées aux revêtements métalliques (7, 8) par des contacts à pression (24), le maintien mécanique étant assuré par l'enrobage (15).

5. Condensateur selon une des revendications 1 à 3, caractérisé en ce que les bandes (11, 12) présentent, avant leurs extrémités fixées (13, 14), des repliures (26) servant à compenser des tolérances dimensionnelles du corps (1) du condensateur.

6. Condensateur selon la revendication 1, caractérisé en ce que, dans une autre exécution, le rétrécissement (25), servant de piège thermique, est composé de deux segments et que les extrémités (13, 14) des bandes bifurquent chacune en deux segments comprenant chacun l'un des segments du rétrécissement (25).

7. Condensateur selon la revendication 1, caractérisé en ce qu'il possède une armature supérieure (5), une armature inférieure (6) et des faces frontales opposées (3, 4) et que les bandes (11, 12) sortant chacune de l'enrobage (15) en plastique sur le côté inférieur du condensateur, sont recourbées ensuite vers les côtés d'extrémité correspondants pour s'étendre le long de ceux-ci jusqu'au côté supérieur du condensateur et se prolonger sur une partie du côté supérieur du condensateur, de manière à former des paires (16, 18 et 17, 19) de faces de contact inférieures et supérieures opposées.

8. Condensateur selon la revendication 6, caractérisé en ce que les bandes (11, 12) présentent des faces de soudage supplémentaires (20, 21 et 22, 23) qui s'étendent chacune sur une partie de la face frontale avant (15) du corps (1) du condensateur ou sur la face frontale arrière, qui lui est opposée.

9. Condensateur selon la revendication 7, caractérisé en ce que les faces de soudage inférieures (16, 17) sont agrandies par des parties de bande (33, 34) recourbées en U.

10. Condensateur selon la revendication 1, caractérisé en ce que les bandes (11, 12) sortent latéralement de l'enrobage (15), sont recourbées ensuite vers le haut et forment des faces de soudage (18, 19) sur le côté supérieur du corps (1) du condensateur.

11. Condensateur selon la revendication 1, caractérisé en ce que, dans une autre exécution du condensateur, des pattes supérieures (31, 32) sont formées dans les extrémités (13, 14) des bandes (11, 12), chaque extrémité (13, 14) des bandes (11, 12) comprenant deux parties repliées vers le haut et une patte (31, 32) qui n'est pas repliée et qui sert de support pour le corps de condensateur (1).

12. Condensateur selon la revendication 1, caractérisé en ce que les bandes (11, 12) sont fixées non pas frontalement aux revêtements métalliques (7, 8) mais marginalement.

13. Condensateur selon la revendication 1, caractérisé en ce que les bandes (11, 12) sont reliées aux revêtements métalliques (7, 8) au droit de leurs angles formés par la face frontale et la face marginale.

14. Procédé pour fabriquer un condensateur électrique selon une des revendications précédentes, selon lequel on pratique d'abord des découpes (28) dans un ruban de métal (27), de manière à former les bandes (11, 12), on place ensuite les corps (1) des condensateurs entre les bandes (11, 12), on les relie aux bandes (11, 12) et on les entoure de l'enrobage (15), caractérisé en ce que l'on forme l'enrobage (15) autour du corps (1) du condensateur et des bandes (11 et 12), de manière que des parties (29, 30) des bandes (11, 12) dépassent à l'extérieur de l'enrobage (15) et que l'on sépare du ruban métallique (27) les parties de bande (29, 30) faisant saillie de l'enrobage (15), parties que l'on recourbe ensuite le long de la surface de l'enrobage (15).

# FIG 1

# FIG 2

# FIG 3

# FIG 4

# FIG 5

# FIG 6

# FIG 7

FIG 8

FIG 9

FIG 10

FIG 11

FIG 12

FIG 13

FIG 14

FIG 15

FIG 16